# EUROPEAN PATENT APPLICATION

(11) **EP 4 187 620 A1**
(43) Date of publication of application: **31.05.2023**
(21) Application number: 21210413.7
(22) Date of filing: 25.11.2021
(51) Int. Cl.: H01L 29/861, H01L 21/329, H01L 29/45, H01L 29/06

(54) **MULTI-FINGER SEMICONDUCTOR DEVICE**

(71) Applicant: Nexperia B.V., 6534 AB Nijmegen (NL)
(72) Inventor: Utzig, Joachim, 22529 Hamburg (DE); Holland, Steffen, 22529 Hamburg (DE); Ritter, Hans-Martin, 22529 Hamburg (DE)
(74) Representative: Pjanovic, Ilija

(57) **Abstract**

The present invention relates to a method for manufacturing a semiconductor device and to a semiconductor device made using this method. It particularly relates to multi-finger semiconductor devices.

The method for manufacturing a semiconductor device of the invention comprises etching an insulating top layer on the silicon substrate using a patterned first masking layer to expose predetermined first regions (R1) of the upper surface of the silicon substrate. A first seed layer (103) is then arranged on the silicon substrate such that the first seed layer covers the etched insulating top layer and contacts the exposed predetermined first regions either directly or via a first metal layer assembly (108). A second masking layer (102) is arranged on the first seed layer and is patterning to expose predetermined second regions (R2) of the first seed layer. Then, copper (105) is grown on the exposed predetermined second regions of the first seed layer by means of electroplating.

## Description

### FIELD

Aspects of the present disclosure relate to a method for manufacturing a multi-finger semiconductor device and to a multi-finger semiconductor device made using this method. The present disclosure particularly relates to multi-finger semiconductor devices having a silicon substrate but may equally relate to devices having another type of semiconductor substrate such as gallium arsenide, indium phosphide, silicon carbide, or gallium nitride.

### BACKGROUND

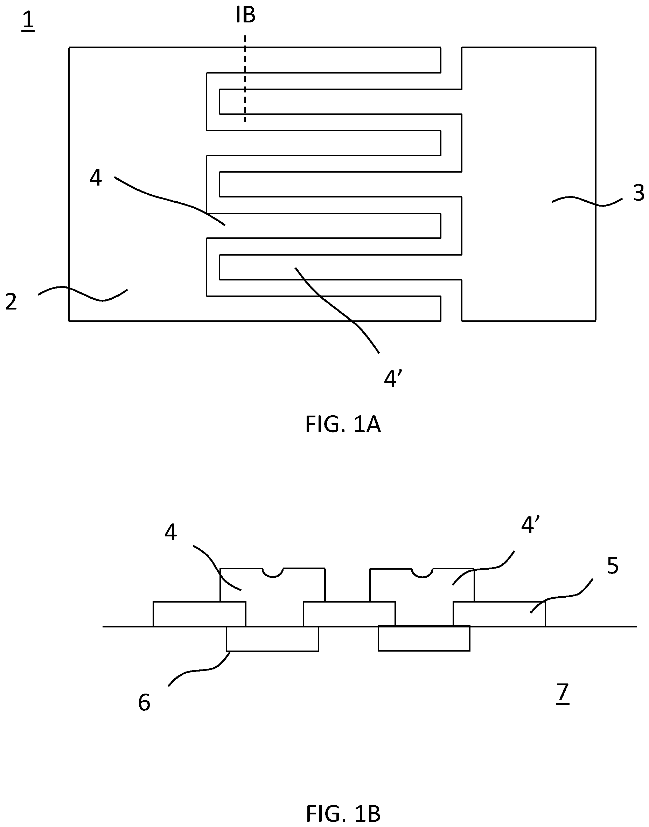

Transient-voltage-suppression, TVS, diodes are semiconductor devices configured for protecting the components they are connected to against voltage spikes. An exemplary top view and a cross-sectional view of a known silicon TVS diode are shown in figures 1A and 1B, respectively. As shown, TVS diodes typically have a multi-finger structure comprising two interdigitated combs, each comb having a base 2,3 from which a plurality of fingers 4, 4' extend, with the diode formed between fingers 4, 4'. The cross-sectional view indicates that a doped contact region 6 is formed in silicon substrate 7 and that the upper surface of silicon substrate 7 is typically covered with an insulating layer, such as thermally grown silicon dioxide 5. In other embodiments of a TVS diode, a contact is formed on the backside of silicon substrate 7.

TVS diodes need to be able to handle large currents. The maximum allowable current per finger is limited by the cross-sectional area of that finger, being the thickness of the finger times the width of the finger, and by the material properties of the metal used for manufacturing the finger, especially the electrical and thermal conductivity. This metal-limit also limits the maximum length of a finger as the maximum allowable current of the diode connected to that finger has to be smaller than the metal limit.

Typically, fingers 4, 4' comprise a first metallization consisting of aluminum of which the thickness is small compared to the width of the finger. Lithography and etching processes do not allow for very thick fingers having a narrow footprint. For TVS diodes with lateral current flow, both the width and the space of the diffusion must be minimized in order to squeeze as much diode as possible into the available space. Small pitches for fingers are therefore preferable.

Long fingers are needed for high current capabilities. If the maximum length of a finger is smaller than the necessary length, more complex measures must be taken such as using a second or even a third metallization on top of the first metallization, adding to process complexity and cost.

### SUMMARY

Aspects of the present disclosure relate to providing a method for manufacturing a multi-finger semiconductor device that addresses the abovementioned problems. This method comprises the steps of a) providing a semiconductor substrate having an insulating layer arranged on top, b) arranging a first masking layer on the insulating top layer and patterning the first masking layer, and c) etching the insulating top layer using the patterned first masking layer to expose predetermined first regions of an upper surface of the semiconductor substrate and removing the patterned first masking layer. Next, in step d) a first seed layer is arranged on the semiconductor substrate such that the first seed layer covers the etched insulating top layer and contacts the exposed predetermined first regions either directly or via a first metal layer assembly. Then, in step e) a second masking layer is arranged on the first seed layer and the second masking layer is patterned to expose predetermined second regions of the first seed layer, wherein the first and second predetermined regions correspond to a plurality of fingers that are arranged in parallel. As a final step f), copper is grown on the exposed predetermined second regions of the first seed layer by means of electroplating.

Copper can be used for manufacturing the fingers. It is deposited with a galvanic process, so no etching is involved. With the method described above, a thick copper metal layer can be used to define relatively high but narrow fingers that are closely spaced allowing longer fingers to be used at a smaller pitch. Furthermore, copper has both better electrical and thermal conductivity than aluminum. Consequently, the abovementioned method allows the limiting factor of the maximum current through the fingers of a device to be alleviated.

The first and second predetermined regions can be mutually aligned, and the second predetermined regions are preferably larger than the first predetermined regions. More in particular, the first and second predetermined regions can be identically shaped with the projections of the center points on the upper surface of the semiconductor substrate coinciding.

The method may further comprise arranging the first metal layer assembly on the etched insulating top layer and the exposed predetermined first regions before performing the step of arranging a first seed layer and after the step of removing the patterned first masking layer. In this case, the first metal layer assembly directly contacts the exposed predetermined first regions. After arranging the first metal layer assembly, e.g. by means of sputtering, a third masking layer can be arranged on the first metal layer assembly. Next, the third masking layer can be patterned and used for etching the first metal layer assembly to leave the first metal layer assembly directly contacting at least the predetermined first regions.

Alternative methods of arranging the first metal layer assembly are equally possible. For example, it may be possible to start with a semiconductor substrate having a bare upper surface, for example by etching the first insulating layer. As a next step, the first metal layer assembly can be arranged on the upper surface. Thereafter, a masking layer, e.g. photoresist, is applied and patterned to define regions in which the first metal layer assembly should be removed. Next, an etching process is performed to remove the exposed parts of the first metal layer assembly. As a final step, a new insulating layer can be thermally grown or otherwise formed on the upper surface in regions outside of the first metal layer assembly. Alternatively, an insulating layer can be deposited on the entire semiconductor substrate after which the insulating layer is selectively etched, e.g. using photolithography techniques, to expose the first metal layer assembly such that it can be contacted by the first seed layer in a next step. Alternatively, the step of providing a semiconductor substrate having an insulating layer arranged on top may comprise providing a semiconductor substrate having a first metal layer assembly directly contacting said predetermined first regions and having said first insulating layer covering a remainder of the semiconductor substrate.

The first metal layer assembly may be configured to act as a barrier against copper diffusing into the semiconductor substrate. In addition, the first metal layer assembly may be configured to provide improved adhesion of the first seed layer compared to the situation in which the first seed layer contacts the semiconductor substrate directly. In case a first metal assembly is not used, and the seed layer contacts the semiconductor substrate directly, the seed layer should have similar functionality.

The direct contact between the first seed layer and the first predetermined regions may constitute an Ohmic contact, or, if the first metal layer assembly is arranged in between the first seed layer and the semiconductor substrate, the direct contact between the first metal layer assembly and the first predetermined regions may constitute an Ohmic contact. Here, an Ohmic contact is construed as an electrical contact having an at least approximately linear relationship between the current through and the voltage over the Ohmic contact.

The method may further comprise the steps of g) removing the patterned second masking layer, and h) partially etching the first seed layer using the grown copper as a masking layer. In other embodiments, where a first metal layer assembly is used, the first metal layer assembly is not etched before arranging the first seed layer. Instead, the grown copper is used as a masking layer to not only etch the first seed layer but also the underlying first metal layer assembly.

The method may further comprise the steps of i) arranging a second insulating layer on the semiconductor substrate to cover the electroplated copper and preferably the first insulating top layer, j) patterning the second insulating layer to expose predetermined third regions of the electroplated copper. Next, in step k) a second seed layer is arranged on the semiconductor substrate such that the second seed layer covers the etched second insulating layer and contacts the exposed predetermined third regions directly or through a second metal layer assembly, and in step 1) a fifth masking layer is arranged on the second seed layer and patterned to expose predetermined fourth regions of the second seed layer. As a final step m) copper is grown on the predetermined fourth regions of the second seed layer by means of electroplating. Here, the third and fourth predetermined regions correspond to the plurality of fingers.

The second insulating layer may for example comprise a photosensitive polyimide layer. This layer can be subjected to photolithography after application thereof on the semiconductor substrate. Alternatively, the second insulating layer may comprise a non-photosensitive layer, such as silicon oxide or silicon nitride. After depositing the second insulating layer, a fourth masking layer can be arranged on the second insulating layer and the fourth masking layer can patterned. Next, the second insulating layer can be etched using the patterned fourth masking layer as a mask for exposing said predetermined third regions.

The third and fourth predetermined regions are preferably mutually aligned. More in particular, the third and fourth predetermined regions can be identically shaped with projections of the center points thereof on the upper surface of the semiconductor substrate coinciding. In addition, the fourth predetermined regions are preferably larger than the third predetermined regions.

The method may additionally comprise the steps of n) removing the fifth masking layer, and p) etching the second seed layer using the grown copper as a masking layer.

The first metal layer assembly and the second metal layer assembly, if applicable, may each comprise, independent from each other, one or more metal layers among the group consisting of Ti, TiW, Ta, TaN, TiN, or combinations thereof. The first seed layer and second seed layer, if applicable, may each comprise, independent from each other, one or more metal layers among the group consisting of Ti, TiW, Ta, TaN, TiN, Cu, or combinations thereof. The first insulating layer may comprise one or more layers among thermally grown silicon dioxide, silicon oxide, and silicon nitride, and/or the second insulating layer, if applicable, may comprise one or more layers among Polyamide, Polyimide, Polybenzoxazole, silicon oxide, and silicon nitride.

The first masking layer, the second masking layer, the third masking layer, the fourth masking layer, and/or the fifth masking layer may each comprise a photoresist layer. Alternatively, other masking layers could be used such as silicon oxide, silicon nitride or the like. Patterning of these layers can be achieved using conventional photolithography and etching techniques.

The semiconductor substrate may be provided with a plurality of doped contact regions formed in the semiconductor substrate underneath the predetermined first regions of the upper surface of the semiconductor substrate. These dopes contact regions lower the contact resistance of the contact between the first seed layer or the first metal layer assembly and the semiconductor substrate.

The semiconductor substrate may comprise a silicon semiconductor. Alternatively, the semiconductor may comprise a GaN, SiC, InP, or GaAs substrate.

A further aspect of the present disclosure relates to a multi-finger semiconductor device comprising a semiconductor substrate having a first insulating layer arranged on top, wherein predetermined first regions of an upper surface of the silicon substrate are not covered by the first insulating layer. The device additionally comprises a first seed layer contacting the predetermined first regions either directly or via a first metal layer assembly, and an electroplated copper layer grown on predetermined second regions of the first seed layer, wherein the first and second predetermined regions correspond to a plurality of fingers that are arranged in parallel. The device may further comprise a second insulating layer covering the first insulating top layer and at least partially the electroplated copper layer, wherein predetermined third regions of the electroplated copper are not covered by the second insulating layer. The device may also comprise a second seed layer contacting the predetermined third regions directly or through a second metal layer assembly, and an electroplated copper layer grown on predetermined fourth regions of the second seed layer, wherein the third and fourth predetermined regions correspond to the plurality of fingers.

The first metal layer assembly and the second metal layer assembly, if applicable, may each comprise, independent from each other, one or more metal layers among the group consisting of Ti, TiW, Ta, TaN, and TiN or combinations thereof. The first seed layer and second seed layer, if applicable, may each comprise, independent from each other, one or more metal layers among the group consisting of Ti, TiW, Ta, TaN, TiN, Cu, or combinations thereof. Furthermore, the first insulating layer may comprise one or more layers among thermally grown silicon dioxide, silicon oxide, and silicon nitride, and/or wherein the second insulating layer, if applicable, comprises one or more layers among Polymide, Polyimide, PBO, silicon oxide, and silicon nitride.

The semiconductor substrate may be provided with a plurality of doped contact regions formed in the semiconductor substrate underneath the predetermined first regions of the upper surface of the semiconductor substrate. The semiconductor substrate may comprise a silicon semiconductor. Alternatively, the semiconductor may comprise a GaN, SiC, InP, or GaAs substrate.

Aspects of the present disclosure particularly relate to a multi-finger device one among the group consisting of resistors, diodes, in particular TVS diodes, bipolar transistors, silicon controlled rectifiers, Shockley diodes, MOS transistors, IGBTs.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figures 1A and 1B present a top view and a cross-sectional view of a known TVS diode, respectively;
Figures 2A-2O illustrates a method of manufacturing a semiconductor device in accordance with the present invention; and
Figures 3A and 3B illustrate a cross-sectional view of respective embodiments of a TVS diode in accordance with the present invention.

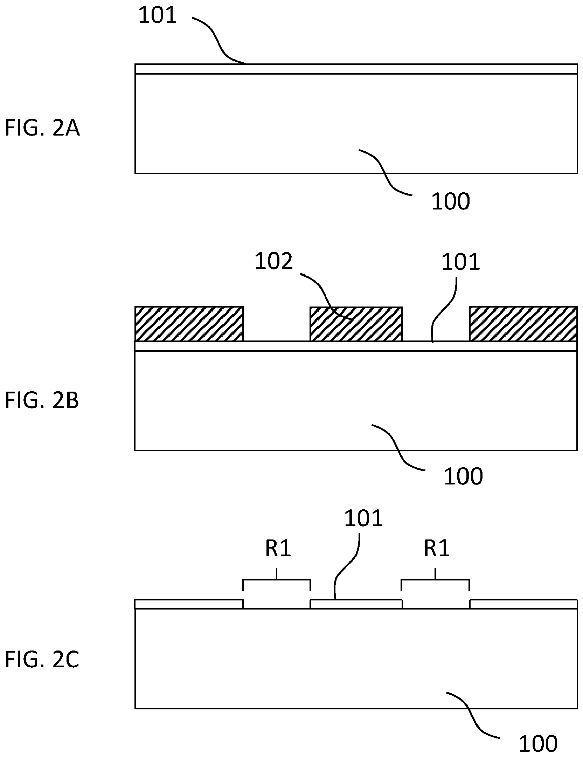

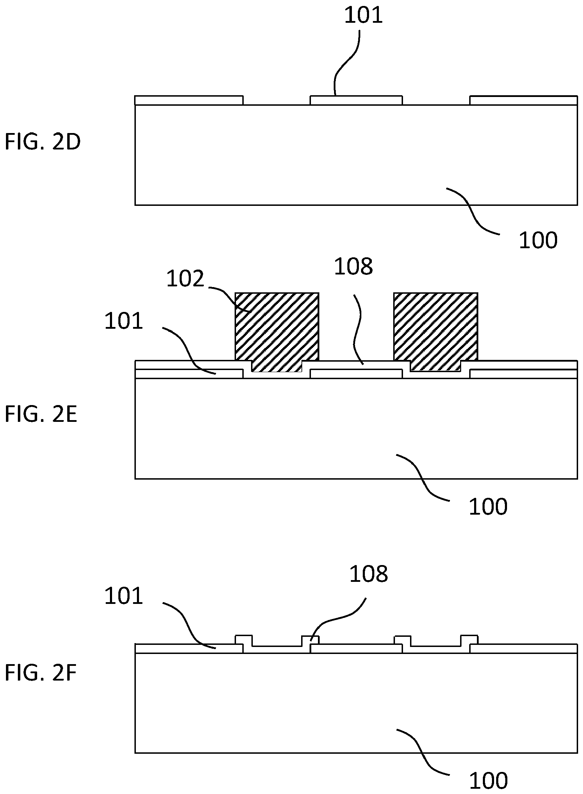

Figures 2A illustrates a silicon substrate 100 that is provided with a silicon dioxide layer 101 on its top surface. This latter layer can be thermally grown.

The situation shown in figure 2A illustrates but one starting point of a method in accordance with one or more aspects of the present disclosure. Another starting point will be discussed in connection with figures 2D-2F.

Starting from figure 2A, next steps are illustrated in figures 2B and 2C. More in particular, a photoresist layer 102 is arranged on silicon dioxide layer 101 and is patterned using photolithography techniques. After patterning, silicon dioxide layer 101 is etched to expose first regions R1 of the upper surface of silicon substrate 100.

The situation shown in figure 2C may optionally serve as a starting point for the steps shown in figures 2D-2F. In these steps, a first metal layer assembly 108 comprising Ti, TiW, Ta, TaN, TiN, or combinations thereof, is deposited on substrate 100. Next, a photoresist layer 102 is arranged over the entire substrate and is patterned. Photoresist layer 102 acts as a mask during an etching step for etching first metal layer assembly 108. Such etching step can be either wet-chemical or may comprise dry etching techniques.

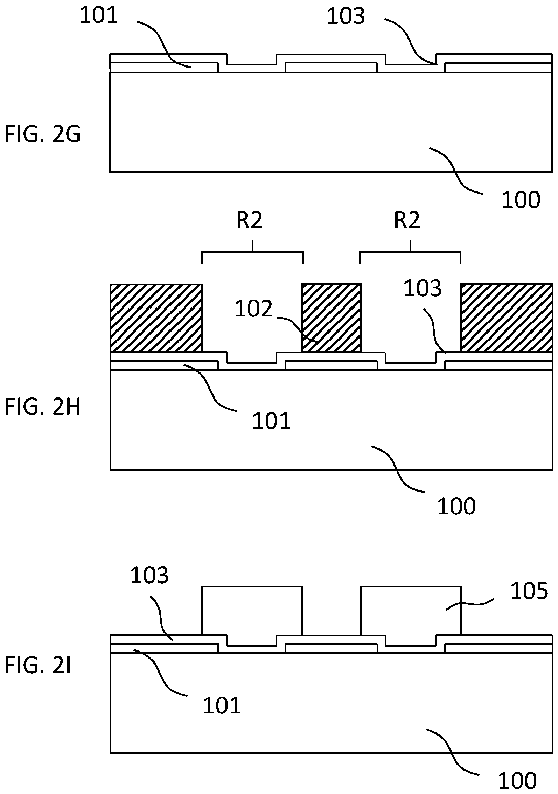

The result after etching is illustrated in figure 2F. Here, regions can be identified where first metal layer assembly 108 is not etched. Both the situation shown in figure 2F, and the situation shown in figure 2C may serve as a starting point for the steps to be discussed next. In the remainder of the discussion on figures 2G-2O, the situation shown in figure 2C will be taken as the starting point.

As a next step shown in figure 2G, a first seed layer 103, such as Ti, TiW, Ta, TaN, TiN, Cu, or combinations thereof is deposited or sputtered on substrate 100. First seed layer 103 will cover silicon dioxide layer 101 and regions R1 of the upper surface of substrate 100. Alternatively, if the starting point of figure 2F would be used, it would cover silicon dioxide layer 101 and first metal layer assembly 108.

Next, as shown in figure 2H, a photoresist layer 102 is applied and patterned to expose second regions R2 of first seed layer 103. Thereafter, copper is grown onto exposed second regions R2 using electroplating, in which process first seed layer 103 is used as one of the electrodes. After plating, photoresist 102 is removed and the situation shown in figure 2I is obtained.

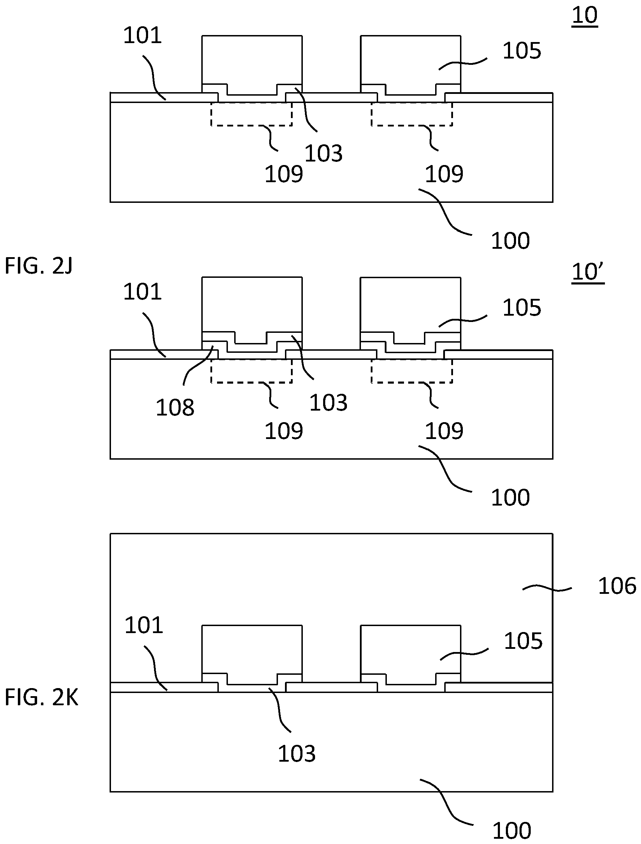

As a next step, shown in figure 2J (top), first seed layer 103 is etched using the grown copper layer 105 as a hard masking layer, thereby resulting in device 10. Figure 2J (bottom) shows a further device 10' that would have resulted in figure 2F had been taken as starting point for figure 2G.

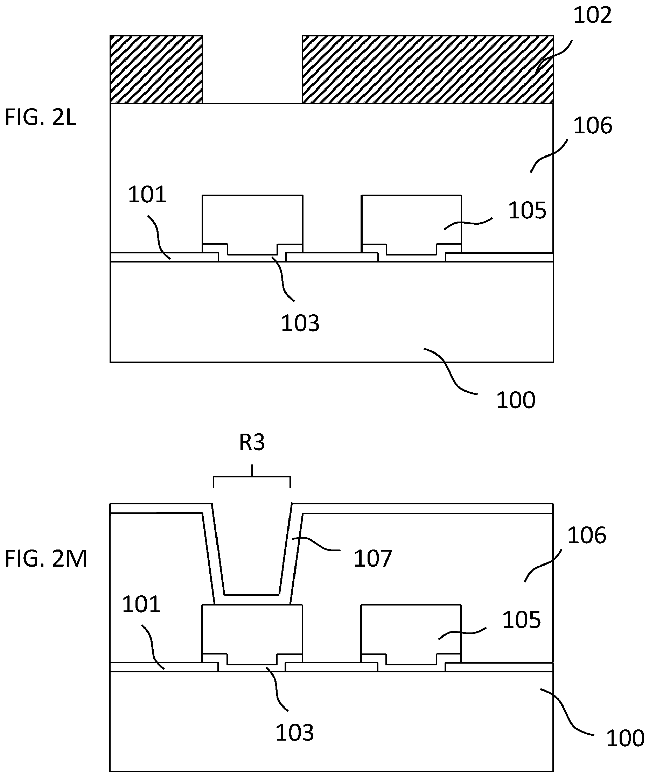

Figures 2K-2O illustrate optional further steps during which a further copper layer can be arranged. This process starts, as shown in figure 2K, by depositing a second insulating layer 106, such as silicon oxide or silicon nitride, on substrate 100. Second insulating layer 106 covers grown copper layer 105 and silicon dioxide layer 101. As shown in figures 2L-2M, a photoresist 102 is arranged on second insulating layer 106 and is subsequently patterned. Next, second insulating layer 106 is etched to expose a third region R3 of grown copper layer 105, and a second seed layer 107, such as Ti, TiW, Ta, TaN, TiN, Cu, or combinations thereof, is deposited or sputtered on etched second insulating layer 106. Instead of using a second insulating layer 105 and separate photoresist layer 102, a photosensitive second insulating layer 105, such as Polyimide, may be used. This latter layer can be patterned directly. In both cases, the situation shown in figure 2M will be obtained.

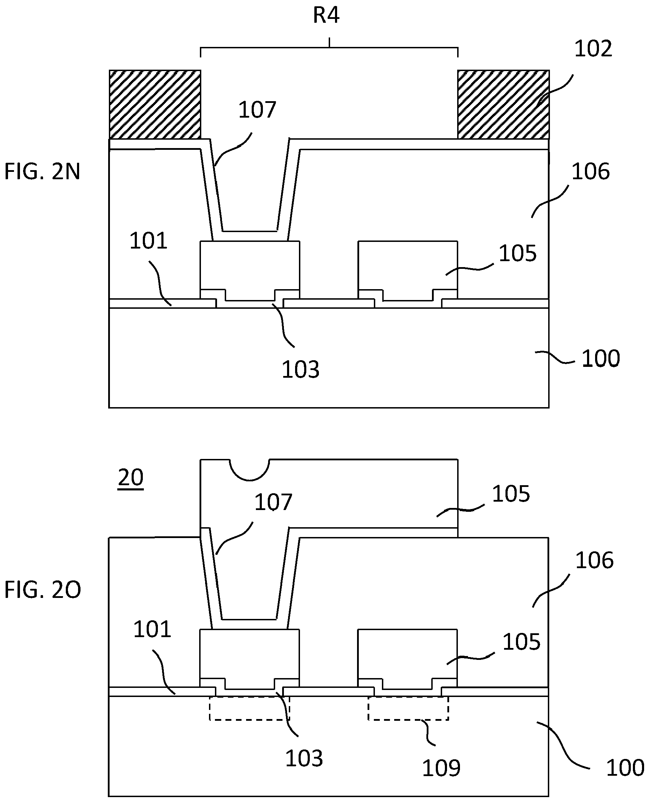

As a next step, shown in figure 2N, a photoresist layer 102 is applied on second seed layer 107 and is patterned to expose a fourth region R4 of second seed layer 107. Thereafter, copper is grown onto exposed fourth region R4 using electroplating, in which process second seed layer 107 is used as one of the electrodes. After plating, photoresist 102 is removed and device 20 shown in figure 2O is obtained.

Shown in figures 2O and 2J are doped contact regions 109 underneath firs regions R1 of the upper surface of silicon substrate 100.

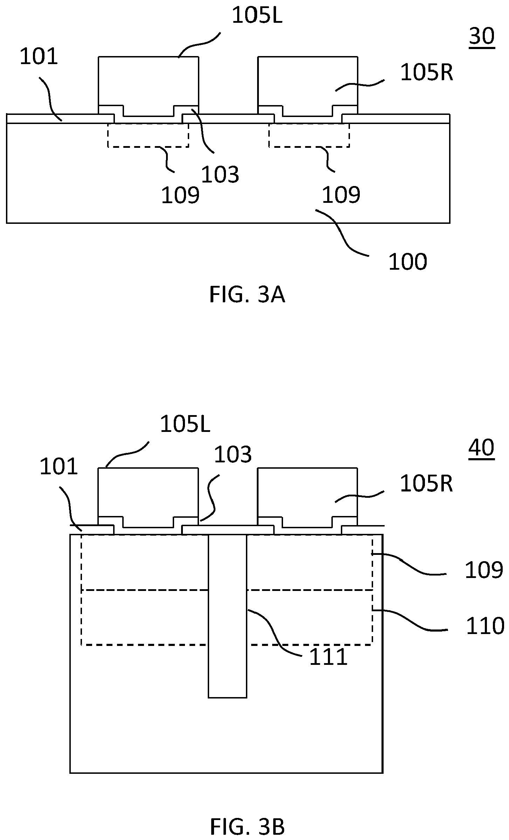

Figures 3A and 3B illustrate a cross-sectional view of a TVS diode 30, 40 in accordance with one or more aspects of the present disclosure, respectively. In figure 3A, an n-type silicon substrate 100 is implanted with p-type dopants for forming p+ contact regions 109. In this manner, back-to-back PN junctions are formed between contacts 105L, 105R. In figure 3B, silicon substrate 100 comprises a p+ region 110 and an n+ region 109. Trenches 111 provide a lateral isolation between contacts 105L, 105R. Semiconductor substrate 100 can be p-type in which case two back-to-back PN junctions are formed between contacts 105L, 105R. Alternatively, semiconductor substrate 100 can be n-type in which case four back-to-back PN junctions are formed between contacts 105L, 105R

It should be appreciated that figures 3A, 3B only show two fingers for illustrative purposes whereas actual devices comprise many more fingers. These devices comprise a repetitive arrangement of that what is shown in figures 3A, 3B. Furthermore, figures 3A-3B relate to TVS diodes whereas aspects of the present disclosure can equally be applied in other multi-finger semiconductor devices such as resistors, diodes, bipolar transistors, silicon-controlled rectifiers, Shockley diodes, MOS transistors, IGBTs.

In the above, the present invention has been described using detailed embodiments thereof. However, the present invention is not limited to these embodiments. Instead, various modifications are possible without departing from the scope of the present invention which is defined by the appended claims and their equivalents.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A method for manufacturing a multi-finger semiconductor device, comprising:
a) providing a semiconductor substrate (100) having an insulating layer (101) arranged on top;
b) arranging a first masking layer (102) on the insulating top layer and patterning the first masking layer;
c) etching the insulating top layer using the patterned first masking layer to expose predetermined first regions (R1) of an upper surface of the semiconductor substrate, and removing the patterned first masking layer;
d) arranging a first seed layer (103) on the semiconductor substrate such that the first seed layer covers the etched insulating top layer and contacts the exposed predetermined first regions either directly or via a first metal layer assembly (108);
e) arranging a second masking layer (102) on the first seed layer and patterning the second masking layer to expose predetermined second regions (R2) of the first seed layer, wherein the first and second predetermined regions correspond to a plurality of fingers that are arranged in parallel; and
f) growing copper (105) on the exposed predetermined second regions of the first seed layer by means of electroplating;
wherein the first and second predetermined regions are preferably mutually aligned, and wherein the second predetermined regions are preferably larger than the first predetermined regions.

2. The method according to claim 1, the method further comprising arranging the first metal layer assembly on the etched insulating top layer and the exposed predetermined first regions before performing the step of arranging a first seed layer and after the step of removing the patterned first masking layer, said first metal layer assembly directly contacting the exposed predetermined first regions.

3. The method according to claim 2, the method further comprising:
arranging a third masking layer (102) on the first metal layer assembly and patterning the third masking layer;
etching the first metal layer assembly using the patterned third masking layer to leave the first metal layer assembly directly contacting at least said predetermined first regions.

4. The method according to claim 1, wherein said providing a semiconductor substrate having an insulating layer arranged on top comprises providing a semiconductor substrate having the first metal layer assembly directly contacting said predetermined first regions and having said insulating layer covering a remainder of the semiconductor substrate.

5. The method according to any of the claims 2-4, wherein the first metal layer assembly is configured to act as a barrier against copper diffusing into the semiconductor substrate.

6. The method according to any of the previous claims, wherein the direct contact between the first seed layer and the first predetermined regions constitutes an Ohmic contact, or, if the first metal layer assembly is arranged in between the first seed layer and the silicon substrate, the direct contact between the first metal layer assembly and the first predetermined regions constitutes an Ohmic contact.

7. The method according to any of the previous claims, the method further comprising:
g) removing the patterned second masking layer; and
h) partially etching the first seed layer using the grown copper as a masking layer.

8. The method according to claim 7, further comprising:
i) arranging a second insulating layer (106) on the semiconductor substrate to cover the electroplated copper and preferably the first insulating top layer;
j) patterning the second insulating layer to expose predetermined third regions (R3) of the electroplated copper;
k) arranging a second seed layer (107) on the semiconductor substrate such that the second seed layer covers the etched second insulating layer and contacts the exposed predetermined third regions directly or through a second metal layer assembly;
1) arranging a fifth masking layer (102) on the second seed layer and patterning the fifth masking layer to expose predetermined fourth regions (R4) of the second seed layer, wherein the third and fourth predetermined regions correspond to the plurality of fingers; and
m) growing copper (105) on the predetermined fourth regions of the second seed layer by means of electroplating;
wherein the third and fourth predetermined regions are preferably mutually aligned, and wherein the fourth predetermined regions are preferably larger than the third predetermined regions.

9. The method according to claim 8, the method further comprising:
o) removing the fifth masking layer; and
p) etching the second seed layer using the grown copper as a masking layer.

10. The method according to any of the previous claims, wherein the first metal layer assembly and the second metal layer assembly, if applicable, each comprise, independent from each other, one or more metal layers among the group consisting of Ti, TiW, Ta, TaN, and TiN, or combinations thereof; and/or
wherein the first seed layer and second seed layer, if applicable, each comprise, independent from each other, one or more metal layers among the group consisting of Ti, TiW, Ta, TaN, TiN, and Cu, or combinations thereof; and/or
wherein the first insulating layer comprises one or more layers among thermally grown silicon dioxide, silicon oxide, and silicon nitride, and/or wherein the second insulating layer, if applicable, comprises one or more layers among Polyamide, Polyimide, Polybenzoxazole, silicon oxide, and silicon nitride; and/or
wherein the first masking layer, the second masking layer, the third masking layer, the fourth masking layer, and/or the fifth masking layer comprises a photoresist layer.

11. The method according to any of the previous claims, wherein the semiconductor substrate is provided with a plurality of doped contact regions formed in the semiconductor substrate underneath the predetermined first regions of the upper surface of the semiconductor substrate, and./or wherein the semiconductor substrate comprises a silicon substrate.

12. A multi-finger semiconductor device (10;10'; 200), comprising:
a semiconductor substrate (100) having a first insulating layer (101) arranged on top, wherein predetermined first regions (R1) of an upper surface of the semiconductor substrate are not covered by the first insulating layer;
a first seed layer (103) contacting the predetermined first regions either directly or via a first metal layer assembly; and
an electroplated copper layer (105) grown on predetermined second regions (R2) of the first seed layer, wherein the first and second predetermined regions correspond to a plurality of fingers that are arranged in parallel.

13. The multi-finger semiconductor device (20) according to claim 12, further comprising:
a second insulating layer (106) covering the first insulating top layer and at least partially the electroplated copper layer, wherein predetermined third regions (R3) of the electroplated copper are not covered by the second insulating layer;
a second seed layer (107) contacting the predetermined third regions directly or through a second metal layer assembly; and
an electroplated copper layer (105) grown on predetermined fourth regions (R4) of the second seed layer, wherein the third and fourth predetermined regions correspond to the plurality of fingers.

14. The multi-finger semiconductor device (10; 10'; 20) according to claim 12 or 13, wherein the first metal layer assembly and the second metal layer assembly, if applicable, each comprise, independent from each other, one or more metal layers among the group consisting of Ti, TiW, Ta, TaN, and TiN or combinations thereof;
wherein the first seed layer and second seed layer, if applicable, each comprise, independent from each other, one or more metal layers among the group consisting of Ti, TiW, Ta, TaN, TiN, and Cu or combinations thereof;
wherein the first insulating layer comprises one or more layers among thermally grown silicon dioxide, silicon oxide, and silicon nitride, and/or wherein the second insulating layer, if applicable, comprises one or more layers among Polymide, Polyimide, Polybenzoxazole, silicon oxide, and silicon nitride; and/or
wherein the semiconductor substrate is provided with a plurality of doped contact regions (109) formed in the semiconductor substrate underneath the predetermined first regions of the upper surface of the semiconductor substrate, and/or wherein the semiconductor substrate comprises a Silicon substrate.

15. The multi-finger semiconductor device (10; 10'; 20) according to any of the claims 12-14, wherein the device is one among the group consisting of resistors, diodes, in particular TVS diodes, bipolar transistors, silicon-controlled rectifiers, Shockley diodes, MOS transistors, and IGBTs.
